# EUROPÄISCHE PATENTANMELDUNG

(11) **EP 3 002 760 A1**
(43) Veröffentlichungstag der Anmeldung: **06.04.2016**
(21) Anmeldenummer: 15187698.4
(22) Anmeldetag: 30.09.2015
(51) Int. Cl.: G11C 16/04, G11C 16/28

(54) **FLASH-SPEICHERANORDNUNG**

(30) Priorität: 30.09.2014 DE 102014114257
(71) Anmelder: Anvo-Systems Dresden GmbH, 01109 Dresden (DE)
(72) Erfinder: Günther, Stefan, 01259 Dresden (DE)
(74) Vertreter: Lippert, Stachow & Partner

(57) **Zusammenfassung**

Die Erfindung, die eine Flash-Speicheranordnung betrifft, beinhaltet erste Speicherzellen zur nichtflüchtigen Speicherung von Informationen und eine Schreib-Leseschaltung. Die Schreib- Leseschaltung enthält ein Write-Latch, einen Leseverstärker, eine Bitleitungsvorladungsschaltung und ein Datenbusinterface, wobei die erste Speicherzelle mit einer ersten Bitleitung, einer Wortleitung, einer VSE-Leitung und einer Selektleitung verbunden ist und die Schreib- Leseschaltung mit einem Spaltendekoder, einem Datenbus und einer Lesesteuersignalleitung verbunden, löst die Nachteile des Standes der Technik, dadurch, dass eine erste Speicherspalte (21) angeordnet ist, derart, dass in einer ersten Teilmatrix (9.1) die erste Speicherzelle (1) angeordnet ist, in der zwischen der ersten Bitleitung BL00 (2) und einem Entladeknoten (3) ein erster Selekttransistor (4), ein Speichertransistor (5) und ein zweiter Selekttransistor (6) angeordnet sind, dass der zweite Selekttransistor (6) mit einem globalen nicht addressdekodierten Selektleitung V_{RW} (10) steuerbar ist, dass an jeder Bitleitung in der ArtBL00 (2) eine Referenzspeicherzelle (7) angeordnet ist, dass eine zweite Teilmatrix (9.2) in der Art der ersten Teilmatrix (9.1) vorgesehen ist, und dass die Schreib- Leseschaltung (8) mit den beiden Bitleitungen (2) und (33) BL00 und BL10 der beiden Teilmatrizen (9.1) und (9.2) verbunden ist und dass die Schreib-Leseschaltung (8) von einem globalen Lesesteuersignal (11) ansteuerbar ist. (Fig. 1)

## Beschreibung

Die Erfindung betrifft eine Flash-Speicheranordnung, mit einer ersten Speicherzelle zur nichtflüchtigen Speicherung von Informationen und einer Schreib-Leseschaltung. Die Schreib- Leseschaltung enthält ein Write Latch, einen Leseverstärker, eine Bitleitungsvorladungsschaltung und ein Datenbusinterface. Dabei ist die erste Speicherzelle mit einer ersten Bitleitung, einer Wortleitung, einer VSE-Leitung und einer Selektleitung verbunden und die Schreib-Leseschaltung mit einem Spaltendekoder, einem Datenbus und einer Lesesteuersignalleitung verbunden.

Als VSE-Leitung wird die Gate-Steuerleitung des Speichertransistors bezeichnet. Sie führt als einziger Knoten der Flash Speicheranordnung eine "high level Spannung", später beschrieben im Schreibvorgang Seite 8 ....

Es sind ein und zwei- Transistorzellen bekannt, die zur Erzeugung von Heißelektronen und deren Speicherung im Speichertransistor Hochspannungen an Drain und Gate benötigen.

Es sind auch zwei- Transistorzellen bekannt, die spannungsgesteuert arbeiten wobei auch bei diesen Hochspannungen auf den Bitleitungen erzeugt und dekodiert werden müssen, wobei nicht jede Bitleitung bzw. jedes Bitleitungspaar einen eigenen Leseverstärker besitzen.

Aus der WO 03/036651 ist das Prinzip eines Leseverstärker und seine Anordnung im Array bekannt.

Die Informationen aus der Bitleitung werden mit Informationen aus dem Spaltendekoder an einen Vorverstärker weitergeleitet und erst danach im Leseverstärker verstärkt, wobei der Referenzpfad mit Referenzzelle und Referenz Vorverstärker nicht Teil des Flash-Arrays ist.

Aus der WO 2011/005665 ist ein NOR-Flash-Array mit einem Hochvolt-Programm-Pufferspeicher und einem Niedriggeschwindigkeits-Seite-Leseverstärker und Niederspannungs-y-Decoder gesteuerten Eingangssignalen für den Leseverstärker bekannt. Dabei erfolgt die Programmierung und damit die Dekodierung mit hohen Spannungen auf den Bitleitungen und Selektleitungen von bis zu 8V.

Die Nachteile des Standes der Technik bestehen darin, dass die bekannten Lösungen im Schreib-Lese-Pfad mit Spannungen im Bereich von 5 - 8V, hier als Hochspannung bezeichnet, arbeiten, was entsprechend große Transistoren erfordert und damit zu größeren Chipflächen, erhöhtem Dekodieraufwand und langsameren Zugriffszeiten führt. Hieraus ergeben sich auch Limitationen für Betriebsspannungs- und Temperaturbereich.

Der Erfindung liegt die Aufgabe zugrunde, die Nachteile des Standes der Technik zu überwinden.

Die Aufgabe wird durch eine Flash-Speicheranordnung der eingangs genannten Art gelöst, bei der eine erste Speicherspalte angeordnet ist, derart, dass in einer ersten Teilmatrix einer Flash-Matrix die erste Speicherzelle angeordnet ist, in der zwischen der ersten Bitleitung und einem Entladeknoten ein erster Selekttransistor, ein Speichertransistor und ein zweiter Selekttransistor angeordnet sind. Der zweite Selekttransistor ist mit einer Selektleitung verbunden und über diese mit einem globalen nicht addressdekodierten Schreib-Lesesignal steuerbar. An jeder Bitleitung ist desweiteren eine Referenzspeicherzelle angeordnet. Weiterhin ist eine zweite Teilmatrix in der Art der ersten Teilmatrix vorgesehen. Die Schreib- Leseschaltung ist mit den beiden Bitleitungen der beiden Teilmatrizen verbunden. Die Schreib- Leseschaltung ist mit einer Lesesteuersignalleitung verbunden und darüber von einem globalen Lesesteuersignal ansteuerbar.

In der Speicherzelle, d.h. der Flash-Zelle, ist zwischen dem die nichtflüchtige Information enthaltenden Speichertransistor und der Bitleitung der erste Selekttransistor einerseits und dem Entladeknoten andererseits der zweite Selekttransistor angeordnet. Dabei selektiert der erste Selekttransistor die zu schreibende Wortleitung und der zweite Selekttransistor wählt global die Lese- oder Schreibfunktion aus.

Der Entladeknoten kann beispielsweise durch Versorgungsspannung, die Masse oder eine low-voltage-Spannungsversorgung realisiert werden, wie dies weiter unten noch beschrieben ist.

Die Teilmatrix enthält neben mindestens einer Wortleitung eine Referenz-Wortleitung.

Die Speicherspalte einer Flash-Matrix ist so ausgebildet, dass jede Lese-Schreibschaltung immer mit zwei Bitleitungen verbunden ist, wobei jede zu unterschiedlichen Teilmatrizen gehört. Jede dieser identischen Bitleitungspaare weist genau eine Schreib-Leseschaltung mit einem Schreib-Latch, einem Leseverstärker, einem Datenbusinterface und einer Vorladeschaltung auf. Die Schreib-Leseschaltung ist des Weiteren sowohl mit mindestens einer globalen Lesesteuersignalleitung als auch spaltendekodierten Signalleitungen verbunden.

Es ist möglich, dass mindestens eine zweite Speicherspalte in der Art der ersten Speicherspalte mit zwei weiteren Bitleitungen angeordnet ist, die sich über die erste und zweite Teilmatrix erstrecken. Damit wird eine Matrix realisiert, bei der mindestens zwei einander entsprechende Speicherzellen der jeweiligen Speicherspalte an einer Wortleitung eine Zeile bilden.

Es ist auch möglich, dass jede der mit derselben Schreib-Leseschaltung verbundenen Bitleitung mit mehreren Speicherzellen in der Art der ersten Speicherzelle versehen ist. Damit können mehrere Zeilen einer Flash-Matrix gebildet werden. Die Anzahl der Zeilen richtet sich nach der Anzahl der Speicherzellen an einer Bitleitung und die Anzahl der Speicherzellen je Zeile richtet sich nach der Anzahl der Speicherspalten.

Eine Ausführung sieht vor, dass jede der Bitleitungen der ersten Teilmatrix und ihre entsprechende Bitleitung der zweiten Teilmatrix mit jeweils einer identischen Anzahl von Speicherzellen in der Art der Speicherzelle verbunden ist.

Es ist auch möglich, dass sich die Flash-Speicheranordnung mit allen Transistoren der Schreib- Leseschaltung, des Spaltendekoders sowie mit allen Speicherzellen ausschließlich der VSE-Leitung in einer low-voltage-Domäne befinden. Damit ist die Matrix Teil der low-voltage-Domäne, d.h es liegt keine Hochspannung an der Schreib-Leseschaltung und Versorgungsspannung der Speicherzellen an. Unter Hochspannung versteht man in diesem Falle Spannungen zwischen 5 bis 8V. Die Spannungen in der low-voltage-Domane liegen deutlich darunter, beispielsweise im Bereich von 1 bis 2V Mit der geringen Versorgungsspannung der low-voltage-Domäne werden die hohe Packungsdichten und kurze Zugriffszeiten sichergestellt.

Eine weitere Möglichkeit besteht darin, dass der Entladeknoten mit der Array-Masse verbunden ist. Damit kann die vorgeladene Bitleitung über die Speicherzelle im Falle eines gelöschten Zustandes der Speicherzelle entladen werden und im Falle einer programmierten Zelle erfolgt diese Entladung der Bitleitung nicht oder langsamer als die Entladung der anderen Bitleitung des Bitleitungspaares am Leseverstärker durch die Referenzspeicherzelle.

Es ist auch möglich, dass erste Speicherzellen mit einem ersten Endladeknoten und über jeweils eine Bitleitung mit einer ersten Schreib- Leseschaltung und zweite Speicherzellen mit einem zweiten Endladeknoten und jeweils über eine Bitleitung mit einer zweiten Schreib-Leseschaltung verbunden sind. Die erste Schreib-Leseschaltung ist zusätzlich von einem ersten Spaltendekoder und die zweite Schreib- Leseschaltung von einem zweiten Spaltendekoder steuerbar. Die ersten und zweiten Speicherzellen sind alternierend mit dem ersten Endladeknoten und dem zweiten Endladeknoten verbunden. Dabei sind alle diese Speicherzellen in Art der Speicherzelle aufgebaut.

Mit dieser getrennten Ansteuerung benachbarter Bitleitungen kann der Zugriff auf diese unabhängig voneinander, logisch als auch zeitlich, erfolgen, wodurch die Wechselwirkungen benachbarter Bitleitungen minimiert werden und damit das dynamische Verhalten verbessert, Störsicherheit und Zuverlässigkeit erhöht werden können.

Bei den Entladeknoten ist es möglich, dass der erste Entladeknoten mit dem zweiten Entladeknoten verbunden ist. Damit sind alle Speicherspalten mit ein und derselben Entladeknoten verbunden.

Es ist auch möglich, dass der erste Entladeknoten und der zweite Entladeknoten mit der Array-Versorgungsspannungsleitung verbunden sind.

Die Erfindung soll nachfolgend anhand eines Ausführungsbeispieles näher erläutert werden. In den zugehörigen Zeichnungen zeigt
- Fig. 1: eine erfindungsgemäße Flash-Speicheranordnung mit zwei Speicherspalten,
- Fig. 2: eine Schreib-Leseschaltung einer Speicherspalte
- Fig. 3: eine erfindungsgemäße Flash-Speicheranordnung mit vier Speicherspalten, jeweils wechselweise verschaltet mit zwei Entladeknoten und
- Fig. 4: eine Schreib-Leseschaltung einer Speicherspalte für wechselseitig verschaltete Entladeknoten.

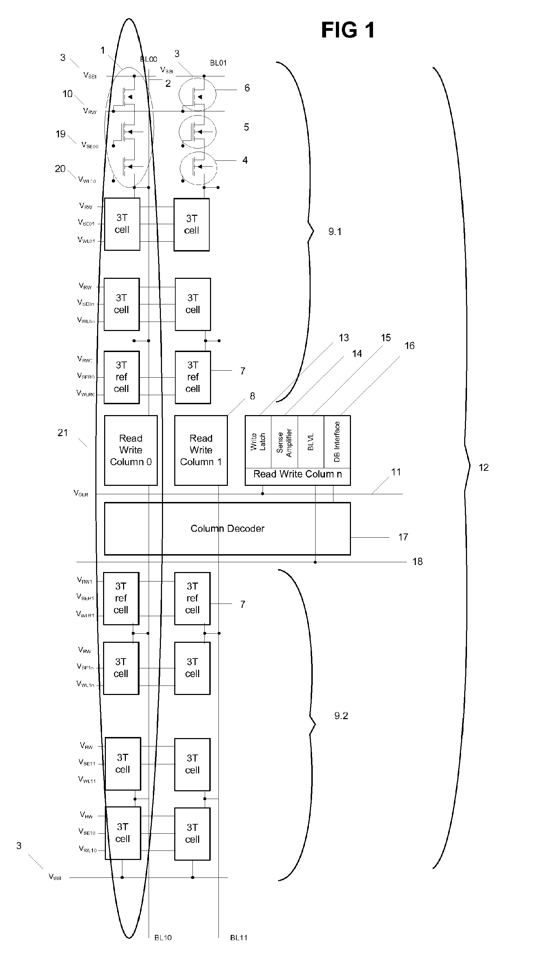

Fig. 1 zeigt eine Flash-Speicheranordnung 12, mit einer ersten Speicherzelle 1 zur nichtflüchtigen Speicherung von Informationen und einer Schreib-Leseschaltung 8. Die Schreib-Leseschaltung 8 enthält einen Write Latch 13, einen Leseverstärker 14, eine Bitleitungsvorladungsschaltung 15 und ein Datenbusinterface 16. Dabei ist die erste Speicherzelle 1, bestehend aus einem ersten Selekttransistor 6, einem nicht-flüchtigem Speichertransistor 5 und einem zweiten Selekttransistor 4, mit einer ersten Bitleitung 2 und einem Entladeknoten 3 (VCCI) verbunden, der Selekttransistor 6, gesteuert von der Selektleitung 10 und verbunden mit dem Entladeknoten 3 (VSSI), und dem Speichertransistor 5, der Speichertransistor 5, gesteuert von VSE-Leitung 19 und weiterhin verbunden mit dem von der Wortleitung 20 gesteuerten zweiten Selekttransitor (6), und die Schreib- Leseschaltung 8 mit einem Spaltendekoder 17, einem Datenbus 18 und einer Lesesteuersignalleitung 11 verbunden sind.

Bei der Flash-Speicheranordnung 12 ist eine erste Speicherspalte 21 angeordnet, derart, dass in einer ersten Teilmatrix 9.1 einer Flash-Speicheranordnung 12 die erste Speicherzelle 1 angeordnet ist. In dieser sind zwischen der ersten Bitleitung 2 und einem Entladeknoten 3 ein erster Selekttransistor 6, ein Speichertransistor 5 und ein zweiter Selekttransistor 4 angeordnet sind. Der Selekttransistor 6 ist mit einer Schreib-Lesesignalleitung 10 verbunden und über diese mit einem globalen nicht addressdekodierten Schreib-Lesesignal V_{RW} steuerbar. An der Bitleitung BL00 oder - gemäß einer Ausführung mit mehreren Bitleitungen - mit jeder Bitleitung (BL00 ... BL0n), ist eine Referenzspeicherzelle 7 verbunden. Weiterhin ist eine zweite Teilmatrix 9.2 in der Art der ersten Teilmatrix 9.1 vorgesehen. Die Schreib-Leseschaltung 8 ist mit den beiden Bitleitungen BL00; BL10 der beiden Teilmatrizen verbunden. Die Schreib- Leseschaltung 8 ist mit der Lesesteuersignalleitung 11 verbunden und darüber von einem globalen Lesesteuersignal V_{GLW} ansteuerbar.

Im Schreibmodus wird eine Speicherzelle 1 durch Anlegen einer Spannung an die Wortleitungs 20 V_{WL00} und über die Leitung BL00 adressiert. Nachfolgend wird eine "high-level-Spannung", beispielsweise in einem Spannungsbereich von ca. 10 Volt, an die VSE-Leitung 19 V_{SE00} angelegt und damit die Leitfähigkeit des zwischen dem ersten Selekttransistor 4 und dem zweiten Selekttransistor 6 angeordneten mittleren Speichertransistor 5 entsprechend des Bitleitungspotentials bleibend verändert oder nicht verändert und derart eine Information, Low oder High, gespeichert. Der zweite Selekttransitor 6 ist über seine Gateleitung 10 nicht leitfähig geschalten. Der Schreibvorgang ist damit beendet.

Im Lesemodus wird wiederum die gesamte Speicherzelle 1 durch eine positive Spannung an der Selektleitung 10 in den Lesemodus versetzt und eine Adressauswahl über die Leitungen 20 V_{WL00} und 2 BL00 vorgenommen. Durch eine an die VSE-Leitung 19 V_{SE00} angelegte Spannung wird auf der zugehörigen Bitleitung BL00 das vorgeladene Potential entsprechend der gespeicherten Information entladen oder nicht bzw. mit unterschiedlichen Geschwindigkeiten entladen.

Zur Feststellung, ob diese Bitleitungspotentiale einer logischen Null oder Eins entsprichen, ist der Einsatz einer Referenzspeicherzelle 7 erforderlich. Diese Referenzspeicherzelle ist Teil der Teilmatrix 9.2 und mit der ebenso vorgeladenen Bitleitung BL10verbunden. Diese Referenzspeicherzelle 7 der Teilmatrix 9.2 wird für alle Speicherzellen einer Bitleitung BL0n der Teilmatrix 9.1 angesteuert.

Durch einen Vergleich der Potentiale der oberen BL00 der ersten Teilmatrix (9.1) und der unteren Bitleitung BL10 der zweiten Teilmatrix (9.2)kann sodann ermittelt werden, ob in der ausgewählten Speicherzelle 1 der ersten Teilmatrix 9.1 eine logische Eins oder Null enthalten war.

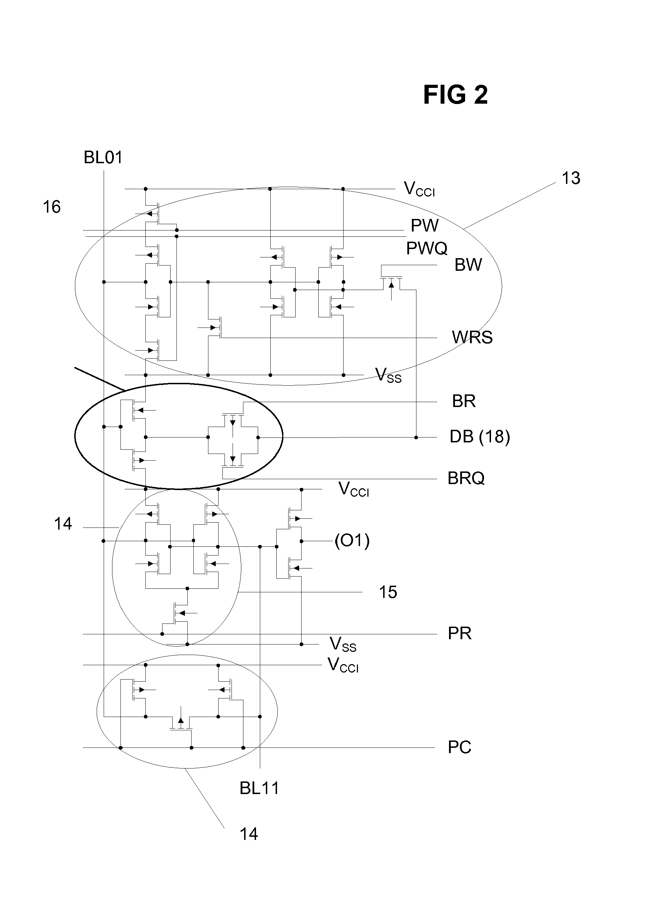

Zur Fig. 2 ist die Schreib-Leseschaltung 8 näher dargestellt. Hierzu wird nachfolgend eine Funktionsbeschreibung gegeben.

Im Schreibmodus werden die zu schreibenden Daten auf dem Datenbus DB 18 bereitgestellt. Das Write-Latch 13 wird mittels der Steuerleitung WRS zurückgesetzt. Mit dem spaltendekodierten Signal BW = High wird der Inhalt auf dem Datenbus DB im Write-Latch 13 gespeichert.

Dies kann für alle Spalten einer Matrix sequentiell erfolgen. D.h. der Datenbus DB weist eine bestimmte Breite auf. Entsprechend dieser Briete wird eine entsprechende Bitanzahl in die Write-Latches 14 parallel geschrieben. Wenn alle zu schreibenden Bytes einer Page in den entsprechenden Write-Latches 13 gespeichert sind, erfolgt mittels der globalen PW- und PWQ Signale (page write / negiertes page write) der Transfer der gelatchten Daten auf die Bitleitung BL01 bzw. der invertierten gelatchten Daten über den Leseverstärker 14 auf BL11 wenn in die zweiten Teilmatrix 9.2 geschrieben werden soll.

Diese Bitleitungsinformation kann in der oberen Teilmatrix in der selektierten Speicherzelle 1 geschrieben werden. Soll eine Information auf die untere, zweite Teilmatrix 9.2 gespeichert werden, wird der Leseverstärker 14 mit dem PR-und bei der alternierenden Anordnung zusätzlich noch mit dem SAS0&1 Signal aktiviert und auf der Bitleitung BL11 steht die in-vertierte Information der Bitleitung BL01 zur Verfügung. Dort kann sie in der ausgewählten Speicherzelle nicht flüchtig gespeichert werden.

Für das Schreiben sind zu den erforderlichen Zeitpunkten die Signale BW = High, WRS = High, PW = Low und PWQ = High und BRQ=Low.Für die Teilmatrix 9.2 noch zusätzlich PR = High und für die alternierende Anordnung zusätzlich SAS0&1 = Low.

Im Lesemodus ist BW=Low, WRS=Low, SAS0&1 = Low, PW=High und PWQ=Low, so dass der Write-Latch 4 inaktiv geschaltet ist. Der Lesevorgang geht von vorgeladenen Bitleitungen BL01 und BL11 aus, was durch die Aktivierung PC bzw. PC0&1=Low der Vorladungsschaltung 15 erreicht wurde. Danach wird die Bitladungsvorladungsschaltung 15 mittels PC bzw. PC0&1 = High deaktiviert. Eine selektierte Wortleitung 20 (VWL0n) in der ersten Teilmatrix 9.1 und die Referenzwortleitung VWLR1 in der zweiten Teilmatrix 9.2 werden gleichzeitig aktiviert. Entsprechend des logischen Inhalts der ausgewählten Speicherzelle 1 in der ersten Teilmatrix 9.1 wird die Bitleitung BL01 schneller oder langsamer entladen als die Bitleitung BL11. Es entsteht ein Differenzsignal zwischen BL01 und BL11. Mittels PR =High wird der Leseverstärker 14 aktiviert und verstärkt dieses Differenzsignal. Die Information an die Bitleitung BL01 wird mittels des Datenbus Interfaces 16 auf den Datenbus 18 DB übertragen.

Soll eine Information aus der zweiten Teilmatrix 9.2 ausgelesen werden, so wird eine Wortleitung VWL1n in der zweiten Teilmatrix 9.2 und die Referenzwortleitung VWLR0 in der ersten Teilmatrix 9.1 ausgewählt. Der Lesevorgang läuft identisch ab und die verstärkte Information steht auf der Bitleitung BL11 und die invertierte Information auf der Bitleitung BL01 zur Verfügung. Über das Datenbus Interface 16 wird diese Information auf den Datenbus 18 negiert übertragen.

Mittels einer an den Anschlusses V_{RW0} bzw. V_{RW1} (aller Zellen einer Teilmatrix) angelegten ersten Steuerspannung können stets die gesamten Zellen 1 einer Page in einem Lesevorgang ausgelesen werden.

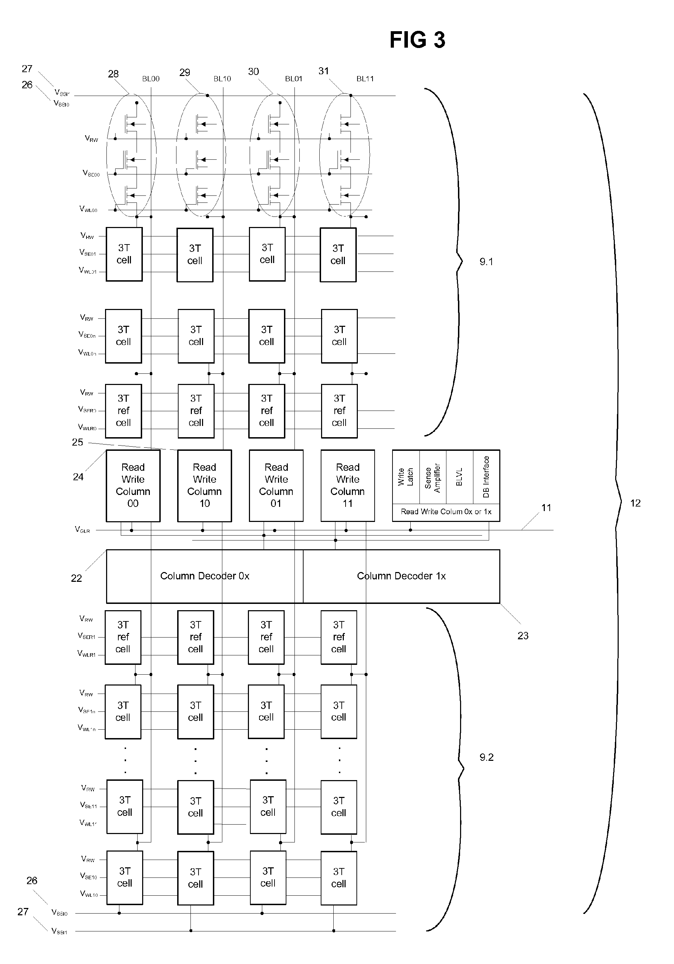

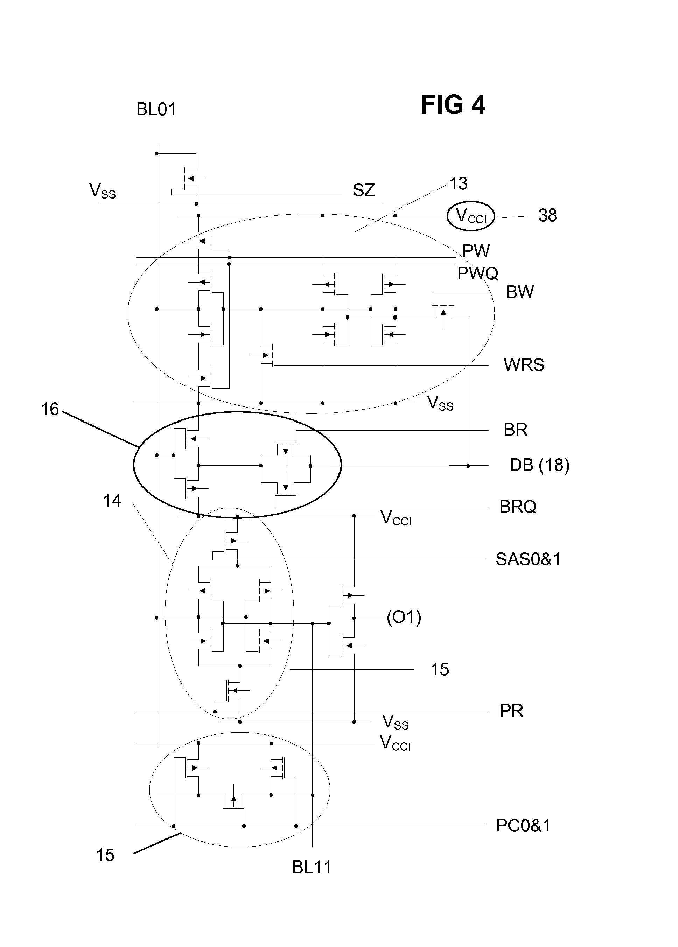

Fig. 3 zeigt eine Flash-Speicheranordnung mit vier Speicherspalten, jeweils wechselweise verschaltet mit zwei Entladeknoten und zwei Spaltendekodern. In dieser Anordnung sind zwischen 2 ausgewählten Zellen auf Bitleitungen BL0n immer spaltendekodierte nicht- selektierte Zellen auf Bitleitungen BL1n angeordnet wobei die spaltendekodierten nicht-selektierten Bitleitungen nicht vorgeladen werden bzw. nicht entladen werden, da das Vorladungspotential identisch dem Entladeknotenpotential VSSI1 ist. Die zugehörige Schreibleseschaltung ist in Fig.4 dargestellt.

Die Vorteile der Erfindung bestehen in folgendem:
a) Mit der erfindungsgemäßen Lösung kann im Silizium (Active) der Flash-Speicheranordnung 12 nur mit der Low-Voltage-Domäne gearbeitet werden, was alle Vorteile der technologischen Skalierung wie
   - Geringer Leistungsverbrauch
   - Geringer Flächenbedarf
   - Hohe Geschwindigkeiten / kurze Zugriffszeiten
   - Hohe Parallelität
   - Nutzbarkeit effektiver Fertigung
   ermöglicht.
b) Die für die nichtflüchtige Speicherung erforderlichen hohen Gatespannungen werden nur an einem Gate der Speicherzelle benötigt, was sehr kleine Transistoren im Speicherarray gestattet und damit die Nutzung der Vorteile der Skalierung ermöglicht.
c) Die On-Pitch Schreib- Leseschaltung ermöglicht extrem kurze Zugriffszeiten
d) Das erfindungsgemäße Referenzzellkonzept mit dem Verzicht auf konventionelle Referenzstromquellen ermöglicht die Robustheit der Lösung.
e) Mit der erfindungsgemäßen Architektur wird das Übersprechen benachbarter Bitleitungen praktisch eliminiert, was wiederum die Störsicherheit erhöht.

### Bezugszeichenliste

- 1: Speicherzelle
- 2: Bitleitung 00
- 3: Entladeknoten
- 4: Selekt Transistor
- 5: Speichertransistor
- 6: zweiter Selekttransistor
- 7: Referenzspeicherzelle
- 8: Schreib- Leseschaltung
- 9: Teilmatrix 9.1 und 9.2
- 10: Selektleitung VRW
- 11: Lesesteuersignalleitung VGLR
- 12: Flash- Speicheranordnung
- 13: Write Latch
- 14: Leseverstärker
- 15: Bitleitungsvorladung
- 16: Datenbus- Interface
- 17: Spaltendekoder
- 18: Datenbus
- 19: VSE-Leitung
- 20: Wortleitung VWLxx
- 21: Speicherspalte
- 22: Spaltendekoder0x
- 23: Spaltendekoderlx
- 24: erste Schreib-Leseschaltung
- 25: zweite Schreib-Leseschaltung
- 26: Versorgungsspannung VSSI0
- 27: Versorgungsspannung VSSI1
- 28: Speicherzelle, erste Speicherzelle
- 29: Speicherzelle, zweite Speicherzelle
- 30: Speicherzelle, erste Speicherzelle
- 31: Speicherzelle, zweite Speicherzelle
- 32: Bitleitung 01
- 33: Bitleitung 10
- 34: Bitleitung 11
- 35: Bitleitung 10 wechselseitig
- 36: Bitleitung 01 wechselseitig
- 37: Bitleitung 11 wechselseitig
- 38: VCCI Leitung

## Patentansprüche

1. Flash-Speicheranordnung, mit einer ersten Speicherzelle zur nichtflüchtigen Speicherung von Informationen und einer Schreib-Leseschaltung, die ein Write Latch (4), einen Leseverstärker (5), eine Bitleitungsvorladungsschaltung (6) und ein Datenbusinterface (7) enthält, wobei die erste Speicherzelle (1) mit einer ersten Bitleitung (2 oder BL00), einer Wortleitung (20), einer VSE-Leitung (19) und einer Selektleitung) (10) verbunden ist und die Schreib-Leseschaltung (8) mit einem Spaltendekoder (17), einem Datenbus (18) und einer Lesesteuersignalleitung (11) verbunden ist, **dadurch gekennzeichnet, dass** eine erste Speicherspalte (21) angeordnet ist, derart, dass in einer ersten Teilmatrix (9.1) die erste Speicherzelle (1) angeordnet ist, in der zwischen der ersten Bitleitung (2 oder BL00) und einem Entladeknoten (3) ein erster Selekttransistor (4), ein Speichertransistor (5) und ein zweiter Selekttransistor (6) angeordnet sind, dass der zweite Selekttransistor (6) mit einer Selektleitung (10) verbunden und über diese mit einem globalen nicht address-dekodierten Schreib-Lesesignal V_{RW} steuerbar ist, dass an jeder Bitleitung (2), (33) eine Referenzspeicherzelle (7) angeordnet ist, dass eine zweite Teilmatrix (9.2) in der Art der ersten Teilmatrix (9.1) vorgesehen ist, und dass die Schreib- Leseschaltung (8) mit den beiden Bitleitungen (2) und (33) der beiden Teilmatrizen (BL00; BL10), verbunden ist und dass die Schreib-Leseschaltung (8) mit einer Lesesteuersignalleitung (11) verbunden und darüber von einem globalen Lesesteuersignal (VGLR) ansteuerbar ist.

2. Flash-Speicheranordnung nach Anspruch 1, **dadurch gekennzeichnet, dass** mindestens eine zweite Speicherspalte in der Art der ersten Speicherspalte mit zwei weiteren Bitleitungen (32) und (34)(BL01, BL11) angeordnet ist, die sich über die erste (9.1)und zweite (9.2) Teilmatrix erstreckt.

3. Flash-Speicheranordnung nach Anspruch 1 oder 2, **dadurch gekennzeichnet, dass** jede der mit derselben Schreib-Leseschaltung (8) verbundene Bitleitung (2), (32) bis (34) mit mehreren Speicherzellen in der Art der ersten Speicherzelle (1) versehen ist.

4. Flash-Speicheranordnung nach Anspruch 3, **dadurch gekennzeichnet, dass** jede der Bitleitungen (2) und (32) (BL00, BL01) der ersten Teilmatrix (9.1) und ihre entsprechende Bitleitung (33) und (34)(BL10, BL11) der zweiten Teilmatrix (9.2) mit jeweils einer identischen Anzahl von Speicherzellen in der Art der Speicherzelle (1) verbunden sind.

5. Flash-Speicheranordnung nach einem der Ansprüche 1 bis 4, **dadurch gekennzeichnet, dass** sich die Flash-Speicheranordnung (12) mit allen Transistoren der Schreib- Leseschaltung (8), des Spaltendekoders (17) sowie alle Speicherzellen ausschließlich der VSE-Leitung (19) in einer low-voltage-Domäne befinden.

6. Flash-Speicheranordnung nach einem der Ansprüche 1 bis 5, **dadurch gekennzeichnet, dass** der Entladeknoten (3) mit der Array-Masse verbunden ist.

7. Flash-Speicheranordnung nach einem Ansprüche 1 bis 6, **dadurch gekennzeichnet, dass** erste Speicherzellen (28; 30) mit einem ersten Endladeknoten (26) und über jeweils eine Bitleitung (BL00 (2)und BL01 (36)) mit einer ersten Schreib- Leseschaltung (24), zweite Speicherzellen (29 und 31) mit einem zweiten Endladeknoten (27) und jeweils über Bitleitungen (BL10 (35)) und (BL11 (37)) mit einer zweiten Schreib-Leseschaltung (25) verbunden sind und dass die erste Schreib-Leseschaltung (24) zusätzlich von einem ersten Spaltendekoder (22) und die zweite Schreib-Leseschaltung (25) von einem zweiten Spaltendekoder (23) steuerbar sind und die Speicherzellen (28), (29), (30) und (31) alternierend mit dem ersten Endladeknoten (26) und dem zweiten Endladeknoten (27) verbunden sind, wobei die Speicherzellen (28), (29), (30) und (31) in Art der Speicherzelle (1) aufgebaut sind.

8. Flash-Speicheranordnung nach Anspruch 7, **dadurch gekennzeichnet , dass** der erste Entladeknoten (26) mit dem zweiten Entladeknoten (27) verbunden ist.

9. Flash-Speicheranordnung nach Anspruch 7, **dadurch gekennzeichnet , dass** der erste Entladeknoten (26) und der zweite Entladeknoten (27) mit der VCCI Leitung (38) verbunden sind.
